# EUROPÄISCHE PATENTSCHRIFT

(11) **EP 2 735 056 B1**
(45) Veröffentlichungstag und Bekanntmachung des Hinweises auf die Patenterteilung: **09.09.2015**
(21) Anmeldenummer: 11743442.3
(22) Anmeldetag: 22.07.2011
(51) Int. Cl.: H01Q 7/00, H01Q 7/04, G01R 33/36

(54) **ANTENNE UND ANTENNENANORDNUNG FÜR MAGNETRESONANZ-ANWENDUNGEN**
ANTENNA AND ANTENNA ARRANGEMENT FOR MAGNETIC RESONANCE APPLICATIONS
ANTENNE ET ENSEMBLE ANTENNE POUR APPLICATIONS À RÉSONANCE MAGNÉTIQUE

(43) Veröffentlichungstag der Anmeldung: 28.05.2014
(73) Patentinhaber: Max-Planck-Gesellschaft zur Förderung der Wissenschaften e.V., 80539 München (DE)
(72) Erfinder: DRIESEL, Wolfgang, 06792 Sandersdorf-Brehna (DE); MILDNER, Toralf, 04157 Leipzig (DE); SCHÄFER, Andreas, 04107 Leipzig (DE); MÖLLER, Harald, 04107 Leipzig (DE)
(74) Vertreter: Hertz, Oliver
(86) Internationale Anmeldenummer: PCT/EP2011/003699
(87) Internationale Veröffentlichungsnummer: WO 2013/013680

(56) Entgegenhaltungen:
- EP-A1- 0 256 370
- EP-A2- 0 317 090
- US-A- 3 973 263
- US-B1- 6 847 210

## Beschreibung

### Gegenstand der Erfindung

Die Erfindung betrifft eine Antenne, die für eine Anregung und/oder Erfassung einer Magnetresonanz (MR) in einem zu untersuchenden Objekt eingerichtet ist. Die Erfindung betrifft des Weiteren eine Antennenanordnung (Antennenarray) für ein MR-Gerät und Verfahren zum Betrieb eines MR-Gerätes, insbesondere Verfahren zur Magnetresonanz-Bildgebung oder Magnetresonanz-Spektroskopie. Anwendungen der Erfindung bestehen insbesondere in der Magnetresonanz-Bildgebung (MR-Bildgebung; auch Magnetresonanz-Tomographie, MRT, oder *magnetic resonance imaging,* MRI) und in der Magnetresonanz-Spektroskopie (MR-Spektroskopie).

### Stand der Technik

Im Folgenden wird auf die nachfolgend aufgelisteten Publikationen Bezug genommen, um den Stand der Technik, insbesondere in Bezug auf die MR-Bildgebung oder MR-Spektroskopie, zu illustrieren.
[1] D.I. Hoult. The NMR receiver: a description and analysis of design. Prog. NMR Spectr. 12: 41-77 (1978).
[2] H.J. Zabel, R. Bader, J. Gehring, W.J. Lorenz. Highquality MR imaging with flexible transmission line resonators. Radiology 165: 857-859 (1987).
[3] M.D. Harpen. The Theory of shielded loop resonators. Magn. Reson. Med. 32: 785-788 (1994).
[4] A. Stensgaard. Optimized design of the shielded-loop resonator. J. Magn. Reson. A 122: 120-125 (1996).
[5] S. Hetzer, T. Mildner, W. Driesel, M. Weder, H.E. Möller. Shielded dual-loop resonator for arterial spin labeling at the neck. J. Magn. Reson. Imaging 29: 1414-1424 (2009).
[6] EP 223 284 B1.
[7] EP 249 298 B1.
[8] J.T. Vaughan, H.P. Hetherington, J.0. Otu, J.W. Pan, G.M. Pohost. High frequency volume coils for clinical NMR imaging and spectroscopy. Magn. Reson. Med. 32: 206-218 (1994).
[9] K.P. Pruessmann, M. Weiger, M.B. Scheidegger, P. Boesiger. SENSE: sensitivity encoding for fast MRI. Magn. Reson. Med. 42: 952-962 (1999).
[10] M.A. Griswold, P.M. Jakob, R.M. Heidemann, M. Nittka, V. Jellus, J. Wang, B. Kiefer, A. Haase. Generalized autocalibrating partially parallel acquisitions (GRAPPA). Magn. Reson. Med. 47: 1202-1210 (2002).
[11] L. Tang, Y.K. Hue, T.S. Ibrahim. Studies of RF shimming techniques with minimization of RF power deposition and their associated temperature changes. Concepts Magn. Reson. Part B (Magn. Reson. Engineering) 39B: 11-25 (2011).
[12] U. Katscher, P. Börnert, C. Leussler, J.S. van den Brink. Transmit SENSE. Magn. Reson. Med. 49: 144-150 (2003).

Die Messung der magnetischen Kernresonanz hat sich, insbesondere in der Medizin, als Bildgebungs- und Analyseverfahren etabliert. Hierbei wird ausgenutzt, dass magnetische Kernmomente im statischen Magnetfeld bei Einstrahlung eines magnetischen Wechselfeldes einer definierten Frequenz ausgelenkt werden können. Die Frequenz (Larmor-Frequenz) bestimmt sich aus der Stärke des statischen Magnetfeldes, **B**₀, und der gyromagnetischen Konstante der untersuchten Atomkerne. Die infolge der Anregung kohärent präzedierenden Kernmomente erzeugen ein magnetisches Induktionssignal, das mit geeigneten Spulen (auch als Antennen bezeichnet) registriert und zur Rekonstruktion eines Bildes genutzt werden kann. Grundsätzlich können dieselben Antennen sowohl zum Anregen, also Senden eines Hochfrequenz-(HF-)Signals, als auch zum Empfang genutzt werden. Es sind Antennen und Antennenanordnungen einer Vielzahl von Bauformen bekannt, die sich in Bezug auf die geometrische Gestaltung, die Abstimmbarkeit auf die gewünschte Larmor-Frequenz, das Signal-zu-Rausch-Verhältnis (*signal-to-noise ratio,* SNR), das Gesichtsfeld (*field of view,* FOV), die Geometrie und insbesondere die Homogenität des Antennen-Feldes unterscheiden.

Mit einer HF-Antenne (Volumen- oder Oberflächenantenne) wird neben dem für die Kernresonanz wichtigen hochfrequenten Magnetfeld (**B**_{HF}-Feld) auch ein hochfrequentes elektrisches Feld (**E**_{HF}-Feld) erzeugt. Das durch Kondensatoren oder durch Kopplung zum **B**_{HF}-Feld erzeugte **E**_{HF}-feld ist konservativ (d.h. es lässt sich eine potentielle Energie definieren). Mit Bezug auf die Kernresonanz hat das **E**_{HF}-Feld unerwünschte Wirkungen. So führt es u.a. zu einem beladungsabhängigen Abstimmungs- und Anpassungsverhalten, zur Kopplung zwischen einzelnen Spulen einer Antennenanordnung, zu Strahlungsverlusten und zur Erwärmung des Untersuchungsobjekts. Der letzte Punkt ist für die medizinische MR-Bildgebung und MR-Spektroskopie wegen der Gefahr einer Überschreitung von Grenzwerten der spezifischen Absorptionsrate (SAR) unter Sicherheitsgesichtspunkten von besonderer Relevanz. Frühe Bemühungen, das unerwünschte **E**_{HF}-Feld auf einen möglichst niedrigen Wert zu reduzieren (z. B. durch eine symmetrische Ansteuerung oder die Verwendung einer so genannten Hochstromsonde, *high current probe*) haben sich bei höheren Frequenzen als nachteilig in Bezug auf die Herstellung und das Abstimm- und Anpassungsverhalten der Antenne erwiesen.

Zur Reduzierung des **E**_{HF}-Feld wurde auch vorgeschlagen, Schleifen- oder Loop-Antennen aus Koaxialleitern bei MR-Verfahren anzuwenden [1 - 5]. Diese Antennen, deren Aufbau aus der Funktechnik bekannt ist, werden wegen der primären Detektion des **B**_{HF}-Feldes auch als "Magnetantennen" bezeichnet. Herkömmliche Magnetantennen zeichnen sich durch einen symmetrischen Aufbau aus und können ohne Symmetrierglied (Balun) und Mantelwellensperre sehr stabil über ein Koaxialkabel gespeist werden. Ein weiteres Charakteristikum ist eine hohe Spulengüte, was bei Sendeantennen durch die damit verbundene Resonanzüberhöhung allerdings zu hohen Strömen und Spannungen führt und den Einsatz entsprechend belastbarer Bauteile erfordert.

Bei einer Magnetantenne überwiegt die magnetische Feldkomponente gegenüber der elektrischen Feldkomponente umso mehr, je geringer der Umfang der Antenne im Vergleich zur Wellenlänge ist. Die Schleife aus einem Koaxialleiter wirkt als Spule und bildet zusammen mit einem abstimmbaren Kondensator einen Schwingkreis hoher Güte. Aus den folgenden Gründen haben herkömmliche Magnetantennen jedoch den Nachteil, dass sie sich bei höheren Frequenzen nicht mit einem Kondensator abstimmen lassen und daher ihre Anwendung auf die Funktechnik im Kurzwellen- und Ultrakurzwellen-Bereich beschränkt ist.

Damit eine Abstimmung der herkömmlichen Magnetantenne durch einen Kondensator möglich ist, muss der Umfang der Schleife kleiner als 1/4 der minimalen Kabelwellenlänge sein. Das ist z.B. bei der von Hetzer et al. [5] beschriebenen Anordnung für 125 MHz (Larmor-Frequenz für Wasserstoffkerne oder "Protonen" in einem statischen Magnetfeld von 2,94 T) gut erfüllt, da hier der Umfang (unter Berücksichtigung der Anschlussleitungen) ca. 0,16 λ entspricht (Spulendurchmesser 6 cm, Länge der Anschlussleiter zur Abstimmeinheit ca. 3 cm, d.h. gesamte Kabellänge ca. 24,8 cm). Die Wellenlänge verringert sich jedoch mit steigenden Frequenzen, so dass oberhalb bestimmter Grenzen eine praktikable Baugröße der abstimmbaren Antenne nicht mehr möglich ist. So entspricht bei 297,2 MHz (Larmor-Frequenz für Protonen bei 6,98 T) der Umfang bei sonst gleicher Dimensionierung ca. 0,37 λ, und die Antenne ist in der konventionellen Ausführungsform aus *Semi-Rigid-*Kabel nicht mehr mit einem Kondensator auf die Larmor-Frequenz abstimmbar. Daher würde der Fachmann schon nach einer groben Abschätzung davon ausgehen, dass oberhalb von ca. 200 MHz (Larmor-Frequenz für Protonen bei 4,70 T) keine Abstimmung mehr möglich wäre.

Als Alternative zur Kondensator-Abstimmung wurde von Röschmann et al. [6, 7] vorgeschlagen, den Kapazitäts- und Induktivitätsbelag von Koaxialleitern für Abstimmzwecke zu nutzen. Vaughan et al. [8] griffen diese Gedanken auf und schlugen die Realisierung von Volumenspulen (so genannte TEM-Resonatoren) nach dem *"Transmission-Line-Prinzip"* vor. Diese Antennen sind zwar bei höheren Frequenzen abstimmbar. Der Aufbau und teilweise auch die Abstimmung verkomplizieren sich jedoch erheblich.

### Aufgabe der Erfindung

Die Aufgabe der Erfindung ist es, eine verbesserte Antenne in Gestalt einer Schleifenantenne (oder: Magnetantenne) bereitzustellen, mit der Nachteile herkömmlicher Antennen vermindert oder vermieden werden. Der Erfindung liegt insbesondere die Aufgabe zugrunde, eine Antenne für ein MR-Gerät bereitzustellen, die bei vorgegebener Geometrie - insbesondere auch für Frequenzen beim Betrieb von MRI-Geräten - mit einem Kondensator abstimmbar ist und durch ein einfaches Abstimmverhalten einen robusten Betrieb ermöglicht. Die Aufgabe der Erfindung ist es weiterhin, eine verbesserte Antennenanordnung bereitzustellen, mit der Nachteile herkömmlicher Antennenanordnungen, insbesondere in Bezug auf eine Kopplung zwischen Antennen über das **E**_{HF}-Feld bzw. über Mantelwellen, vermindert oder vermieden werden. Die Aufgabe der Erfindung ist es auch, ein verbessertes MR-Gerät bereitzustellen, das mit einer Schleifenantenne oder Magnetantenne ausgestattet ist. Schließlich ist es auch die Aufgabe der Erfindung, ein verbessertes Verfahren zum Betrieb der Antenne oder Antennenanordnung bereitzustellen. Das Verfahren soll insbesondere einen robusteren Betrieb eines MR-Geräts ermöglichen.

Weitere Antennen sind in US 3 973 263 A, US 6 847 210 B1, EP 0 256 370 A1 und EP 0 317 990 A2 beschrieben.

### Zusammenfassung der Erfindung

Diese Aufgabe wird durch eine Antenne, eine Antennenanordnung, ein MR-Gerät bzw. Verfahren mit den Merkmalen der unabhängigen Ansprüche gelöst. Vorteilhafte Ausführungsformen und Anwendungen der Erfindung ergeben sich aus den abhängigen Ansprüchen.

Gemäß einem ersten Gesichtspunkt der Erfindung wird die genannte Aufgabe durch die allgemeine technische Lehre gelöst, eine Antenne, insbesondere für ein MR-Gerät, bereitzustellen, die für eine Anregung einer Magnetresonanz und/oder für einen Empfang eines Magnetresonanzsignals in einem zu untersuchenden Objekt eingerichtet ist und eine Schleifenantenne bildet. Die erfindungsgemäße Antenne umfasst eine Leiterschleife mit einem Innenleiter und einem primären Schirmleiter (Außenleiter), die mindestens einen Wellenleiter mit einer vorbestimmten Schleifenform bilden. Speisepunkte der Antenne befinden sich vorzugsweise an den Enden der Leiterschleife. Die Leiterschleife ist an mindestens einem der Speisepunkte mit mindestens einem Abstimmungs-Kondensator (Tune-Kondensator), vorzugsweise mindestens einem veränderlichen Abstimmungs-Kondensator, verbunden. Der primäre Schirmleiter ist entlang des Verlaufs oder Umfangs der Leiterschleife (Umfangsrichtung oder Längsrichtung der Leiterschleife) an mindestens einer Stelle durch einen Spalt unterbrochen. Der Spalt, der auch als Trennspalt, Schlitz, "Gap" bezeichnet wird, erstreckt sich quer zur Umfangsrichtung der Leiterschleife, so dass der primäre Schirmleiter in azimutaler Richtung (Umfangsrichtung des Wellenleiters quer zur Umfangsrichtung) vollständig unterbrochen ist.

Des Weiteren umfasst die erfindungsgemäße Antenne einen sekundären Schirmleiter, der sich im Bereich des mindestens einen Spaltes befindet und diesen überdeckt. Der sekundäre Schirmleiter umgibt den primären Schirmleiter, wobei zwischen beiden Schirmleitern ein elektrisch isolierendes Material (Dielektrikum) angeordnet ist. Vorzugsweise umgibt der sekundäre Schirmleiter den primären Schirmleiter allseitig derart, dass der mindestens eine Spalt in azimutaler Richtung vollständig abgedeckt ist.

Die Erfinder haben durch Simulationsrechnungen und den Aufbau eines Prototypen feststellen können, dass die erfindungsgemäße Antenne überraschenderweise auch dann durch den mindestens einen Abstimmungs-Kondensator abgestimmt werden kann, wenn die Länge der Leiterschleife (Umfang der Schleifenantenne) größer als ein Viertel der im Wellenleiter anregbaren Wellenlänge ist. Die Abstimmbarkeit mit dem Abstimmungs-Kondensator wird durch die Abdeckung des mindestens einen Spalts durch den sekundären Schirmleiter erzielt. Ein weiterer wichtiger Vorteil der erfindungsgemäßen Antenne besteht darin, dass sie sich gegenüber herkömmlichen Schleifenantennen auf Wellenleiterbasis durch einen vergrößerten Abstimmbereich auszeichnet.

Vorteilhafterweise bildet die erfindungsgemäße Antenne einen Wellenleiter, der in Bezug auf mindestens eine Larmor-Frequenz mit dem mindestens einen Abstimmungs-Kondensator oder optional (bei Abstimmung auf mehrere Larmor-Frequenzen) mit zusätzlichen Tank-Kreisen resonant abstimmbar ist. Die Funktion der erfindungsgemäßen Antenne baut auf der Tatsache gemäß der Leitungstheorie auf, dass Wellenleiter Reaktanzen nach den bekannten Transformationsformeln transformieren und dass im Bereich des mindestens einen Spalts im Wellenleiter Ströme austreten, die außen über den primären Schirmleiter in Richtung zu den Speisepunkten abfließen. Dadurch wirkt der primäre Schirmleiter als zusätzliche, in Bezug auf den Wellenleiter in Reihe geschaltete Induktivität, die kapazitiv durch den erfindungsgemäß vorgesehenen sekundären Schirmleiter teilweise überbrückt wird. Damit wird der Abstimmbereich im Vergleich zu herkömmlichen Magnetantennen oder Schleifenantennen hin zu höheren Frequenzen, also jenseits der durch λ/4 definierten Grenze bei herkömmlichen Schleifenantennen, ausgedehnt.

Als weiterer Vorzug gegenüber konventionellen Schleifenantennen werden durch die sekundäre Schirmung der erfindungsgemäßen Antenne **E**_{HF}-Felder im Bereich des Untersuchungsobjekts reduziert, was unter den oben ausgeführten Gesichtspunkten und insbesondere unter Sicherheitsaspekten von besonderer Bedeutung ist. Gleichzeitig wird eine Unempfindlichkeit gegenüber elektrischen Feldern aus der Umgebung erzielt. Weiterhin sei angemerkt, dass diese Unempfindlichkeit gegenüber elektrischen Feldern in vorteilhafter Weise einen verminderten Empfang von Rauschen aus Rauschquellen der Umgebung bewirkt, so dass das SNR verbessert wird. Schließlich bewirkt dies auch eine reduzierte Kopplung zu benachbarten erfindungsgemäßen Schleifenantennen, so dass eine Verwendung einer erfindungsgemäßen Antennenanordnung als Array vorteilhaft wird. Schließlich bestehen auch Vorteile der erfindungsgemäßen Antenne darin, dass sie einfach und kostengünstig herstellbar ist.

Vorteilhafterweise bestehen verschiedene Varianten der Wellenleiter-Gestaltung. Beispielsweise kann der primäre Schirmleiter einen einzigen Spalt aufweisen, der vorzugsweise in Bezug auf die Speisepunkte der Antenne symmetrisch, z. B. auf halber Länge der Leiterschleife, angeordnet ist. In diesem Fall ist der sekundäre Schirmleiter in Umfangsrichtung der Leiterschleife vorzugsweise ebenfalls symmetrisch in Bezug auf die Speisepunkte angeordnet, und Abschnitte gleicher Länge des primären Schirmleiters bleiben durch den sekundären Schirmleiter unbedeckt. Die symmetrische Anordnung des Spalts in Bezug auf die Speisepunkte kann Vorteile in Bezug auf die Unterdrückung von Mantelwellen im Wellenleiter haben, die andernfalls durch optional vorgesehene Symmetrierglieder und/oder Mantelwellensperren unterdrückt werden könnten.

Optional kann der primäre Schirmleiter mehrere Spalte aufweisen. Vorzugsweise sind die Spalte für einen symmetrischen Aufbau der Antenne in Umfangsrichtung der Leiterschleife in Bezug auf die Speisepunkt gleichmäßig verteilt angeordnet. Wenn mehrere Spalte vorgesehen sind, überdeckt der sekundäre Schirmleiter mindestens einen der Spalte. Es kann vorgesehen sein, dass ein einziger Spalt von den mehreren Spalten, eine Gruppe von Spalten oder alle Spalte durch den sekundären Schirmleiter abgedeckt sind. Der sekundäre Schirmleiter kann sich entlang der Länge der Leiterschleife über die Spalte erstrecken oder aus mehreren, voneinander getrennten Abschnitten des sekundären Schirmleiters (sekundäre SchirmleiterAbschnitte), die jeweils einen oder mehrere der Spalte überdecken, zusammengesetzt sein.

Alternativ ist eine nicht-symmetrische Anordnung des Spalts oder der Spalte möglich, was Vorteile für die gezielte Beeinflussung der Feldverteilung der erfindungsgemäßen Antenne haben kann, z.B. um eine inhomogene Ausbreitung des **B**_{HF}-Feldes im Gewebe zu modifizieren, was insbesondere bei hohen Magnetfeldstärken von Vorteil wäre.

Gemäß weiteren bevorzugten Ausführungsformen der Erfindung weist der sekundäre Schirmleiter mindestens eines der folgenden Merkmale auf. Vorzugsweise ist der sekundäre Schirmleiter in Bezug auf den mindestens einen Spalt symmetrisch angeordnet, d. h. die Längen des sekundären Schirmleiters, die den primären Schirmleiter beidseitig des Spalts überdecken, sind gleich. Vorteilhafterweise wird damit die Gleichmäßigkeit des mit der erfindungsgemäßen Antenne erzeugten Magnetfeldes verbessert. Des Weiteren kann der sekundäre Schirmleiter den Wellenleiter im Bereich des Spalts in azimutaler Richtung vollständig umgeben. Dies kann Vorteile für die oben genannte kapazitive Überbrückungsfunktion des sekundären Schirmleiters haben. Alternativ kann der sekundäre Schirmleiter in Umfangsrichtung der Leiterschleife eine Unterbrechung, z.B. einen Schlitz aufweisen. In diesem Fall können sich Vorteile für die Unterdrückung von Wirbelströmen ergeben. Des Weiteren kann der sekundäre Schirmleiter eine Hülsenform aufweisen. In diesem Fall ist der sekundäre Schirmleiter mit einer geschlossenen Oberfläche, z.B. aus einem Metallblech oder einer Metallfolie gebildet. Alternativ kann der sekundäre Schirmleiter eine Oberfläche mit Unterbrechungen, z.B. in Netz- oder Spiralform, aufweisen. Die Auswahl von einer dieser Varianten kann für die Optimierung der genannten kapazitiven Überbrückungsfunktion des sekundären Schirmleiters von Vorteil sein. Des Weiteren besitzt die Netz- oder Spiralform ebenfalls Vorteile für die Unterdrückung von Wirbelströmen.

Die Funktion des erfindungsgemäß vorgesehenen sekundären Schirmleiters kann vorteilhafterweise in Abhängigkeit von dessen elektrischer Verbindung mit dem primären Schirmleiter beeinflusst werden. Beispielsweise kann sich der sekundäre Schirmleiter gemäß einer ersten Variante auf freiem Potential ("Floating") befinden. Gemäß weiteren Varianten, die einzeln oder in Kombination vorgesehen sein können, kann das Dielektrikum zwischen dem primären Schirmleiter und dem sekundären Schirmleiter durch mindestens eine Kapazität, mindestens eine Induktivität oder mindestens eine Diode überbrückt sein.

Neben der Einfachheit des Aufbaus der Antenne liegt ein weiterer Vorteil der Erfindung in der Variabilität bei der Auswahl und Anordnung der Leiterschleife. Die Leiterschleife kann gemäß einer bevorzugten Variante der Erfindung durch einen einzigen Ring (z.B. kreisförmig oder elliptisch) oder ein einziges Vieleck (z.B. ein Rechteck oder ein Rhombus) gebildet werden und sich in einer Ebene oder entlang einer gekrümmten Fläche erstrecken. Ausdrücklich in die Erfindung einbezogen sind weitere, von der klassischen Leiterform abweichende Gestaltungsmöglichkeiten mit von der Rechteckform oder Kreisform abweichenden Formen.

Gemäß einer abgewandelten Variante kann die Leiterschleife mindestens zwei Ringe und/oder Vielecke bilden, die einen einzigen Schwingkreis bilden und sich in einer gemeinsamen Ebene erstrecken oder relativ zueinander geneigt, z. B. senkrecht oder mit einem anderen Winkel, angeordnet sein können. Wenn die Ringe und/oder Vielecke getrennt ansteuerbar sind und mehrere Schwingkreise bilden, wird eine Antennenanordnung geschaffen (siehe unten).

Gemäß weiteren abgewandelten Varianten kann die Leiterschleife eine Kreuzung oder Überschneidung des Wellenleiters aufweisen. Beispielsweise kann die Leiterschleife eine Form gemäß der Ziffer Acht aufweisen. Bei diesen Varianten können sich Vorteile für die Formung der Antennencharakteristik ergeben.

Gemäß einer besonders bevorzugten Ausführungsform der Erfindung umfasst die Leiterschleife ein Koaxialkabel, dessen Enden die Speisepunkte der Antenne bilden. Vorteilhafterweise wird die Herstellung der Antenne durch die Verwendung eines biegsamen Koaxialkabels vereinfacht. Der Innenleiter des Koaxialkabels bildet den Innenleiter der Antenne, während der Außenleiter des Koaxialkabels den primären Schirmleiter bildet. Vorzugsweise ist der mindestens eine Spalt im primären Schirmleiter symmetrisch zu den Speisepunkten angeordnet. Das Koaxialkabel trägt auf der Oberfläche des Außenleiters, d.h. auf dem primären Schirmleiter, eine Isolatorschicht, die das Dielektrikum zwischen den primären und sekundären Schirmleitern der erfindungsgemäßen Antenne bereitstellt. Der sekundäre Schirmleiter wird durch eine elektrisch leitende Schicht, z.B. aus einem Metall, wie Kupfer, Silber, Gold oder Aluminium, oder aus einer Metall-Legierung, wie Messing oder Neusilber, oder aus einem Metall-Graphit-Verbund auf der Isolatorschicht gebildet.

Die Wahl der Dicke und Art des Dielektrikums zwischen dem primären und dem sekundären Schirmleiter und des Überdeckungsbereichs durch den sekundären Schirmleiter beeinflusst die Ausdehnung des Abstimmbereichs hin zu höheren Frequenzen (insbesondere jenseits der bei herkömmlichen Schleifenantennen durch λ/4 definierten Grenze). Die Länge des sekundären Schirmleiters kann insbesondere in Abhängigkeit von den Bedingungen bei der Herstellung der Antenne und der Einstellung einer gewünschten Resonanzfrequenz der Antenne frei gewählt werden. Gemäß einer bevorzugten Ausführungsform der Erfindung ist jedoch vorgesehen, dass der sekundäre Schirmleiter in Umfangsrichtung der Leiterschleife eine Länge hat, die mindestens die 3-fache Breite des abgedeckten Spaltes beträgt.

Gemäß der Erfindung ist eine Verstellbarkeit des sekundären Schirmleiters vorgesehen. Dabei ist die Länge des sekundären Schirmleiters in Umfangsrichtung der Leiterschleife veränderlich. Hierzu umfasst der sekundäre Schirmleiter mindestens zwei Schirmleiterabschnitte, die miteinander elektrisch verbunden und relativ zueinander verschiebbar sind. Beispielsweise kann der sekundäre Schirmleiter durch zwei verschiebbare Metallhülsen gebildet werden, wobei die Länge des sekundären Schirmleiters von der gegenseitigen Position der übereinandergeschobenen Metallhülsen abhängt.

Für die Herstellung und Funktion der erfindungsgemäßen Antenne hat es sich als vorteilhaft erwiesen, wenn die Dicke des Dielektrikums zwischen den primären und sekundären Schirmleitern mindestens 10 µm, vorzugsweise mindestens 50 µm, beträgt. Bevorzugte Materialien des Dielektrikums sind Polyolefine, wie z.B. Polyethylen oder Polypropylen. In diesem Fall ergeben sich Vorteile für die Herstellung des Dielektrikums, z.B. durch ein Aufschrumpfen eines Schlauchs. Alternativ können Polytetrafluorethylen (PTFE) oder Phenolharze oder bei geeigneter Halterung des sekundären Schirmleiters ein Inertgas, Luft oder Vakuum als Dielektrikum verwendet werden. Gemäß einer weiteren Alternative kann das Dielektrikum ein Metalloxid, wie z.B. Aluminiumoxid oder Titandioxid, oder ein Mineral, eine Keramik oder ein Glas umfassen. In diesem Fall können sich Vorteile für die Herstellung des Dielektrikums durch einen Auftrag einer Metalloxid-Paste ergeben.

Gemäß einer weiteren bevorzugten Ausführungsform der Erfindung weist die Antenne eine Abstimmeinrichtung auf, die den mindestens einen Abstimmungs-Kondensator enthält und mit der die Antenne auf mindestens eine Larmor-Frequenz abstimmbar ist. Vorteilhafterweise kann damit die erfindungsgemäße Antenne einfach an verschiedene MR-Untersuchungsaufgaben, z.B. an die Messung eines speziellen oder verschiedener Atomkerne angepasst werden. Es besteht eine hohe Variabilität bei der Gestaltung der Abstimmeinrichtung, die zum Beispiel zur Abstimmung verschiedener Teile (Einzelresonatoren) einer erfindungsgemäßen Antennenanordnung (siehe unten) auf unterschiedliche Larmor-Frequenzen oder zur Abstimmung vorbestimmter Teile einer erfindungsgemäßen Antenne oder Antennenanordnung auf mehrere Larmor-Frequenzen eingerichtet sein kann. Die Abstimmeinrichtung kann ein Netzwerk von Reaktanzen (Kapazitäten und/oder Induktivitäten) umfassen, das mit der erfindungsgemäßen Antenne verbunden ist. Vorzugsweise ist die Abstimmeinrichtung elektromagnetisch abgeschirmt, z. B. in einem Gehäuse auf Massepotential angeordnet.

Die Flexibilität der Anpassung an verschiedene Messbedingungen kann vorteilhafterweise erhöht werden, wenn die Antenne gemäß einer weiteren Ausführungsform der Erfindung eine Schalteinrichtung aufweist, über welche die Antenne mit der Abstimmeinrichtung verbunden ist und mit der die Empfindlichkeit der Antenne veränderlich ist. So kann es in Abhängigkeit von der konkreten Anwendung bzw. der konkreten Lage des interessierenden Gebietes im Objekt erforderlich sein, erfindungsgemäße Leiterschleifen teilweise oder ganz zu öffnen, zu verstimmen oder ggf. kurzzuschließen. Hierzu werden besonders bevorzugt PIN-Dioden (*positive intrinsic negative diodes*) ggf. in Kombination mit Kapazitätsdioden (Varaktor-Dioden) und/oder weiteren Reaktanzen verwendet. Vorteilhafterweise wird damit auch eine Fernbedienung der Schalteinrichtung ermöglicht.

Soll eine erfindungsgemäße Schleifenantenne geöffnet werden, so schaltet man mittels einer Steuergleichspannung mit einer PIN-Diode eine geeignet dimensionierte Induktivität parallel zu einem spannungsfesten Kondensator (beispielsweise dem Abstimmungs-Kondensator) im Resonanzkreis. Die schaltbare Induktivität ist dabei so bemessen, dass sie mit dem ausgewählten Kondensator einen Parallelresonanzkreis bei der gewünschten Frequenz bildet.

Soll eine erfindungsgemäße Schleifenantenne verstimmt werden, so schaltet man mittels einer Steuergleichspannung mit einer PIN-Diode eine geeignet dimensionierte Kapazität (oder auch eine Kapazitätsdiode) parallel oder ggf. in Serie zum Abstimmungs-Kondensator im Resonanzkreis. Die schaltbare Kapazität ist dabei so bemessen, dass sie den Resonanzkreis auf die gewünschte neue Frequenz abstimmt. Das gezielte Verstimmen kann als Zwischenstufe zur Optimierung von Empfindlichkeitsprofilen bei bestimmten Anwendungen nützlich sein (*HF-Shimming,* lokale Anregung, lokaler Empfang).

Soll hingegen eine erfindungsgemäße Schleifenantenne kurzgeschlossen werden, so ist dies am einfachsten zu erreichen, indem mittels einer Steuergleichspannung eine leitfähig geschaltete PIN-Diode den Speise- und Terminierungsanschluss der Schleifenantenne überbrückt.

Vorteilhafterweise kann die erfindungsgemäße Antenne ausschließlich als Sendeantenne ausgebildet sein. In diesem Fall sind die Schleifenantenne und der übrige Aufbau für die beim Senden auftretenden Spannungen im Kilovoltbereich ausgelegt. Die erfindungsgemäße Antenne oder Antennenanordnung kann über mindestens einen Abstimmungs-Kondensator bzw. ein Abstimmnetzwerk und eine Anpassungsanordnung im Sendefall mit dem Sender verbunden werden. Alternativ kann die erfindungsgemäße Antenne ausschließlich als Empfangsantenne ausgebildet sein. In diesem Fall sind die erfindungsgemäße Schleifenantenne oder Antennenanordnung für die beim Empfang auftretenden Spannungen im Millivoltbereich ausgelegt und an einen Vorverstärker angeschlossen.

Bevorzugt ist die erfindungsgemäße Antenne oder Antennenanordnung jedoch als Sende-Empfangs-Antenne ausgebildet. In diesen Fall ist jede erfindungsgemäße Schleifenantenne über einen Umschalter entweder mit einem Empfänger oder einem Sender des MR-Gerätes koppelbar. Der Umschalter wird wegen seiner Funktion auch als T/R-Umschalter (*"Transmitter*/*Receiver"-*Umschalter) bezeichnet.

Zusammengefasst sind drei Maßnahmen verfügbar, um die erfindungsgemäße Antenne auf mindestens eine Larmorfrequenz einzustellen und die einzeln oder in Kombination realisiert sein können. Diese Maßnahmen umfassen die Dimensionierung des mindestens einen Abstimmungs-Kondensators, die Einstellung einer Länge des sekundären Schirmleiters entlang des Verlaufs der Leiterschleife und die Einstellung einer kapazitiven und/oder induktiven Kopplung des sekundären Schirmleiters mit dem primären Schirmleiter. Die Einstellung kann bei der Herstellung der Antenne fest vorgegeben werden, oder es kann vorgesehen sein, dass die Einstellung der fertigen Antenne, z. B. zwischen verschiedenen Betriebsphasen variiert wird.

Gemäß einem zweiten Gesichtspunkt der Erfindung wird die genannte Aufgabe durch die allgemeine technische Lehre gelöst, eine Antennenanordnung bereitzustellen, die eine Vielzahl von erfindungsgemäßen Antennen umfasst. Die Antennenanordnung ist eine zu einem Feld (Array) zusammengefasste Gruppe von Antennen. Sie ist zur Erzeugung und zum Empfang von magnetischen Wechselfeldern im Nahfeld, insbesondere für den Einsatz zur MR-Bildgebung und MR-Spektroskopie, eingerichtet. Sie eignet sich besonders beim Senden zur lokalen Anregung von begrenzten Gebieten oder zur Homogenisierung der Anregung insbesondere bei der Untersuchung biologischer Gewebe bei höheren Frequenzen. Beim Empfang von MR-Signalen zeichnet sie sich durch eine Erhöhung des SNR in spulennahen Bereichen und/oder eine beschleunigten Bildaufnahme aus.

Ein weiterer wichtiger Vorteil der erfindungsgemäßen Antennenanordnung besteht in der einfachen Realisierung. Mit einer Aneinanderreihung von mehreren erfindungsgemäßen Antennen kann ein dreidimensionales Array geschaffen werden, das ggf. geometrisch an eine vorbestimmte Form des zu untersuchenden Objekts, z.B. an eine zu untersuchende Körperregion (z.B. den Kopf oder ein Gelenk) angepasst werden kann und eine hohe Flexibilität bezüglich des Einsatzes ermöglicht.

Die Anordnung erfindungsgemäßer Antennen als Array erlaubt neben einer Verbesserung des SNR die Anwendung von Techniken zur (empfangsseitigen) parallelen MR-Bildgebung (z.B. im Ortsraum nach dem "SENSE-Verfahren" [9] oder im *k*-Raum nach dem "GRAPPA-Verfahren" [10]. Damit lässt sich u.a. die räumliche und/oder zeitliche Auflösung im MR-Experiment verbessern. Weiterhin erzielt eine Anordnung erfindungsgemäßer Antennen bei entsprechender Ansteuerung über multiple, unabhängige Sendekanäle eine verbesserte Homogenität des **B**_{HF}-Feldes im Untersuchungsobjekt (so genanntes "HF*-Shimming*" [11]) und gestattet die Anwendung paralleler Sendetechniken [12].

Eine erfindungsgemäße Antennenanordnung kann aus einzelnen erfindungsgemäßen Antennen oder aus Gruppen von erfindungsgemäßen Antennen so aufgebaut sein, dass die einzelnen Antennen bzw. die Gruppen einzelner Antennen eigenständige und separat ansteuerbare resonante Strukturen (Schwingkreise) bilden. Dabei können die Antennen, die eine Antennenanordnung bilden, verschiedene Formen und/oder Größen aufweisen. Insbesondere lässt sich eine erfindungsgemäße Antennenanordnung dadurch realisieren, dass separate erfindungsgemäße Antennen mit Abstand, aneinander grenzend oder teilweise überlappend angeordnet werden und so ein Array aus Einzelresonatoren bilden.

Beispielsweise können mindestens zwei Antennen in Form von Ringen und/oder Vielecken vorgesehen sein, die eine Antennenanordnung bilden. Dabei können die mindestens zwei Ringe und/oder Vielecke mit einer Phasendifferenz von z. B. 0°, 90° oder 180° angesteuert werden. In speziellen Fällen, z.B. bei der Untersuchung biologischer Gewebe bei relativ hohen Larmor-Frequenzen (z.B. bei ca. 300 MHz) können auch von 0°, 90° oder 180° abweichende Phasendifferenzen vorteilhaft sein.

Die Anordnung erfindungsgemäßer Antennen kann eindimensional entlang einer geraden oder gekrümmten Reihe von Antennen vorgesehen sein. Ferner können senkrecht zur Richtung der eindimensionalen Reihe erfindungsgemäße Antennen (Einzelresonatoren) mehrfach nebeneinander angeordnet werden, so dass ein zweidimensionales Array gebildet wird.

Die Antennenanordnung muss sich nicht notwendigerweise längs einer Geraden oder Ebene im Raum erstrecken, sondern kann sich auch längs einer gekrümmten Linie oder eines Polygonzuges oder einer gekrümmten Bezugsfläche erstrecken. Es kann insbesondere vorteilhaft sein, orthogonal zueinander ausgerichtete erfindungsgemäße Antennen in Quadratur zu betreiben. Dies führt zu einer Verringerung der erforderlichen Sendeleistung und zu einem verbesserten SNR beim Empfang. Diese Vorteile basieren insbesondere auf der Erkenntnis, dass es bei in Quadratur betriebenen Spulen zu einer Halbierung der erforderlichen Sendeleistung kommt, und dass sich im Empfangsfall das SNR um den Faktor 1,4 erhöht.

Mit einer Antennenanordnung, die sich entlang einer gekrümmten Bezugsfläche erstreckt, wird ein dreidimensionales Array erhalten. Die geometrische Form der dreidimensionalen Antennenanordnung kann an die Form des zu untersuchenden Objekts (bzw. der zu untersuchenden Teilbereiche des Untersuchungsobjekts) angepasst werden, was zu optimalen Voraussetzungen, sowohl für das Einstrahlen der HF als auch im Empfangsfall führt. In Verbindung mit der Einstellbarkeit der Antennenempfindlichkeit können somit in einem MR-Gerät alle gewünschten Richtungen und/oder Amplituden des **B**_{HF}-Felds im zu untersuchenden Objekt erzeugt (senden) oder detektiert (empfangen) werden.

Die Antennen können vorteilhafterweise auf einer derart gekrümmten Bezugsfläche angeordnet sein, dass ein Untersuchungsraum gebildet wird, der zur Aufnahme des zu untersuchenden Objekts eingerichtet ist. Die gekrümmte Bezugsfläche schließt einen Hohlraum ein, in dem das Objekt im MR-Gerät angeordnet werden kann.

Gemäß einer weiteren Modifizierung der Erfindung können mehrere erfindungsgemäße Antennen, ggf. mit den genannten Variationen, in einer Richtung senkrecht zur Ebene der Leiterschleife übereinander angeordnet sein. Die erfindungsgemäße Antennenanordnungen bildet einen Stapel. Vorteilhafterweise ergibt sich in diesem Fall, z.B. bei unterschiedlich abgestimmten bzw. entkoppelten Antennen, ein weiterer Freiheitsgrad in der Anordnung von Einzelantennen sowie eine größere Anordnungsdichte.

Gemäß einem dritten Gesichtspunkt wird die genannte Aufgabe der Erfindung durch die allgemeine technische Lehre gelöst, ein MR-Gerät bereitzustellen, das mindestens eine erfindungsgemäße Antenne und/oder mindestens eine erfindungsgemäße Antennenanordnung umfasst.

Vorzugsweise kann die mindestens eine erfindungsgemäße Antenne im MR-Gerät so angeordnet sein, dass die Antennenempfindlichkeit in radialer Richtung relativ zum statischen Magnetfeld des MR-Geräts maximal ist, wobei sich Vorteile für eine hohe Empfindlichkeit der MR-Untersuchung ergeben können. Alternativ können die Elemente einer erfindungsgemäßen Antennenanordnung gegenüber der Richtung des statischen Magnetfeldes verdreht (z. B. längs einer Helix) angeordnet sein. Durch Verkippung der Elemente einer erfindungsgemäßen Antennenanordnung relativ zum statischen Magnetfeld kann ein Kompromiss zwischen einer hohen Empfindlichkeit (Detektion eines hochfrequenten Kerninduktionssignals in einer Richtung senkrecht zur Achse des statischen Magnetfelds) sowie einer vorteilhaften Ausnutzung von Parallelbildgebungstechniken (z.B. Verbesserung der räumlichen Auflösung in Richtung der Achse des statischen Magnetfelds) erhalten werden.

Gemäß einem vierten Gesichtspunkt wird die genannte Aufgabe der Erfindung durch die allgemeine technische Lehre gelöst, ein Verfahren zur MR-Bildgebung oder MR-Spektroskopie an einem zu untersuchenden Objekt bereitzustellen, bei dem eine Anregung und/oder eine Erfassung einer Magnetresonanz in dem Objekt mit mindestens einer erfindungsgemäßen Antenne und/oder mindestens einer erfindungsgemäßen Antennenanordnung vorgesehen ist. Das Verfahren zeichnet sich insbesondere durch eine verbesserte Handhabung der mindestens einen Antenne aus und ermöglicht somit eine Optimierung der Untersuchung.

Das erfindungsgemäße Verfahren ermöglicht des Weiteren, dass die Antenne oder Antennenanordnung als Sende-Antenne, Empfangs-Antenne oder als Sende-Empfangs-Antenne oder im alternierenden Betrieb oder für eine sendeseitige oder empfangsseitige Parallelbildgebungs-Technik oder eine Kombination aus beiden Verfahren verwendet wird.

### Kurzbeschreibung der Zeichnungen

Weitere Einzelheiten und Vorteile der Erfindung werden im Folgenden unter Bezugnahme auf die beigefügten Zeichnungen beschrieben. Es zeigen:
- Figuren 1 bis 3:: Ausführungsformen von erfindungsgemäßen Antennen;
- Figuren 4 bis 8:: Ausführungsformen von erfindungsgemäßen Antennenanordnungen;
- Figuren 9 bis 11:: weitere Ausführungsformen von erfindungsgemäßen Antennen;
- Figuren 12 bis 14:: weitere Ausführungsformen von erfindungsgemäßen Antennenanordnungen; und
- Figur 15:: eine schematische Illustration einer bevorzugten Ausführungsform eines erfindungsgemäßen MR-Geräts mit Antennenanordnung.

### Bevorzugte Ausführungsformen der Erfindung

Ausführungsformen der Erfindung werden im Folgenden unter beispielhaftem Bezug auf Antennen beschrieben, deren Leiterschleife mindestens eine Schleife aus einem koaxialen Wellenleiter mit mindestens einem Spalt und zusätzlichem sekundären Schirmleiter über dem mindestens einen Spalt umfasst. Die Umsetzung der Erfindung ist nicht auf die dargestellten Beispiele beschränkt, sondern in entsprechender Weise mit Schleifenanordnungen realisierbar, die anders geformte Schleifen und/oder andere Formen von Wellenleitern aufweisen.

Des Weiteren wird die Erfindung im Folgenden unter beispielhaftem Bezug auf Antennen beschrieben, die sich entlang einer ebenen Bezugsfläche (Bezugsebene) erstrecken. Die Umsetzung der Erfindung ist entsprechend mit gekrümmten Bezugsflächen möglich. Obwohl im Folgenden die Speisepunkte der Antenne an den Enden der Leiterschleife illustriert sind, können die Speisepunkte alternativ an anderen Abschnitten des Wellenleiters einer Antenne vorgesehen sein.

Schließlich ist anzumerken, dass die unten angegebenen Kapazitätswerte Beispielwerte darstellen, die bei der praktischen Anwendung insbesondere in Abhängigkeit von der Beladung der Antennen durch biologische Gewebe den Gegebenheiten angepasst werden können. Der Fachmann kann die Beispielwerte als Startwerte verwenden, um nach an sich bekannten Simulationsrechnungen und einer Feinabstimmung, zum Beispiel unter Verwendung eines Netzwerkanalysators, zu Werten für eine konkrete Anwendung zu gelangen. Für Simulationsrechnungen kann z.B. die Software HFSS™ (High Frequency Structure Simulator; Hersteller: Ansys, Inc., Canonsburg, PA, USA) in Kombination mit der Software Ansoft Designer™ (Hersteller: Ansys, Inc.) verwendet werden.

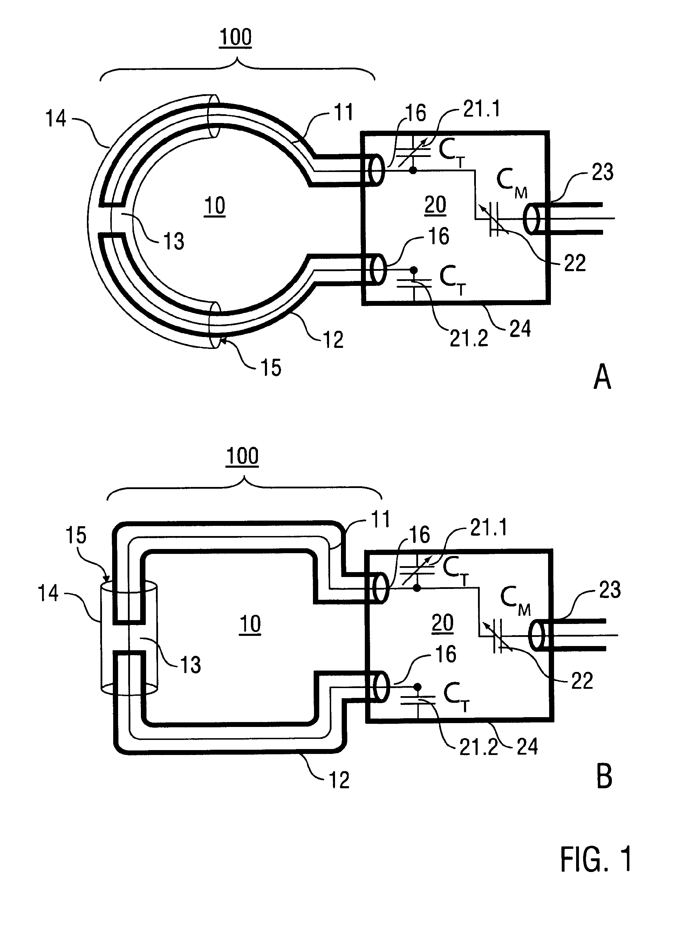

Die Figuren 1A und 1B illustrieren schematisch Ausführungsformen der erfindungsgemäßen Antenne 100. In beiden Fällen umfasst die Antenne 100 jeweils eine Leiterschleife 10 mit einem Innenleiter 11 und einem primären Schirmleiter 12, die einen Wellenleiter bilden. Der primäre Schirmleiter 12 weist einen Spalt 13 auf, der durch einen sekundären Schirmleiter 14 abgedeckt ist. Zwischen den primären und sekundären Schirmleitern 12, 14 befindet sich ein Dielektrikum 15. Durch die Enden des Wellenleiters werden die Speisepunkte 16 der Antenne 100 gebildet.

Die Speisepunkte 16 sind mit zwei Abstimmungs-Kondensatoren 21.1 und 21.2 (C_{T}) verbunden, die Terminierungskondensatoren bilden und in einem geschirmten Gehäuse 24 einer Abstimmeinrichtung 20 angeordnet sind. Die Abstimmeinrichtung 20 enthält des Weiteren einen Anpassungs-Kondensator 22 (C_{M}), der über eine abgeschirmte Leitung 23 mit einem HochfrequenzGenerator (nicht dargestellt) verbunden ist. Als Kondensatoren 21.1, 21.2, 22 werden üblicherweise verlustarme Keramikkondensatoren verwendet. Die Abstimmeinrichtung 20 dient somit der Ein- und Auskopplung der HF-Leistung. Alternativ zu der veranschaulichten kapazitiven Ankoppelung der erfindungsgemäßen Antenne 10 sind andere Koppelvarianten möglich.

Der Leiterschleife 10 der Antenne 100 wird aus einem möglichst kurzen Koaxialleiter hergestellt (schwaches **E**_{HF}-Feld), der eine möglichst große Fläche einschließt. Bei der Ausführungsform der Figur 1A wird daher eine kreisförmige Schleife verwendet. Aus konstruktiven Gründen kann es aber auch sinnvoll sein, eine elliptische Form, eine Rechteckform (siehe Figur 1B) oder andere Vielecke zu benutzen. Der Wellenleiter kann insbesondere aus einem nichtmagnetischen *Semi-Rigid-*Kabel (Festmantelkabel) hergestellt sein. Vorzugsweise hat der Leiter eine möglichst große Oberfläche, weil aufgrund des *Skin*-Effekts bei den in der MR-Bildgebung üblichen Larmor-Frequenzen nur die äußerste Schicht des Leiters wesentlich zur Leitungsfähigkeit beiträgt. Für den Aufbau der Antenne 100 wird zum Beispiel Koaxialkabel (kommerziell erhältliches *Semi-Rigid-*Kabel) mit einem Radiusverhältnis von 3,6 verwendet, da bei dieser Dimensionierung die geringsten Verluste auftreten. Dies entspricht einem Wellenwiderstand von 50 Q. Abweichende Werte sind ebenfalls nutzbar. Im Ausführungsbeispiel beträgt die Länge des Wellenleiters ca. 23,8 cm, wobei zwei Anschlussleiter von jeweils ca. 2,5 cm Länge die Verbindung zur Abstimmeinrichtung 20 herstellen und der restliche Teil zu einer Kreisschleife mit einem Durchmesser von ca. 6 cm gebogen wurde. Der Spalt 13 im primären Schirmleiter 12 hat eine Breite von ca. 1 mm. Er befindet sich an einer Position, die der halben Länge des Wellenleiters entspricht (d.h. den Speisepunkten 16 gegenüberliegend).

Auf den primären Schirmleiter 12 des *Semi-Rigid-*Kabels (Außendurchmesser ca. 3,6 mm) ist als Dielektrikum 15 Schrumpfschlauch (Polypropylen) mit einer Wandstärke von etwa 0,5 mm aufgebracht. Auf diesem Dielektrikum 15 ist als sekundärer Schirmleiter 14 eine Metallisierung aus selbstklebender Kupferfolie symmetrisch zum Spalt 13 aufgebracht. Der so gebildete sekundäre Schirmleiter 14 brückt kapazitiv einen Teil der Induktivität des primären Schirmleiters 12, wodurch die Resonanzfrequenz der Antenne 100 im Vergleich zum Ergebnis der konventionellen, einfach geschirmten Variante zu höheren Frequenzen verschoben wird. In der Ausführungsform von Figur 1A wird die Leiterschleife 10 entlang einer Länge, die etwa dem halben Kreisumfang entspricht (ca. 9,5 cm) mit dem sekundären Schirmleiter 14 doppelt geschirmt. Damit wird erreicht, dass die Antenne 100 bei vorzugsweise gleichen Werten für die Abstimmungs-Kondensatoren 21.1 und 21.2 von ca. 15 pF problemlos auf eine Frequenz von 297,2 MHz abgestimmt werden kann. Abweichend von diesen Werten ist auch eine andere Dimensionierung möglich. Es wird angemerkt, dass als Dielektrikum auch Luft (oder Vakuum) vorgesehen sein kann.

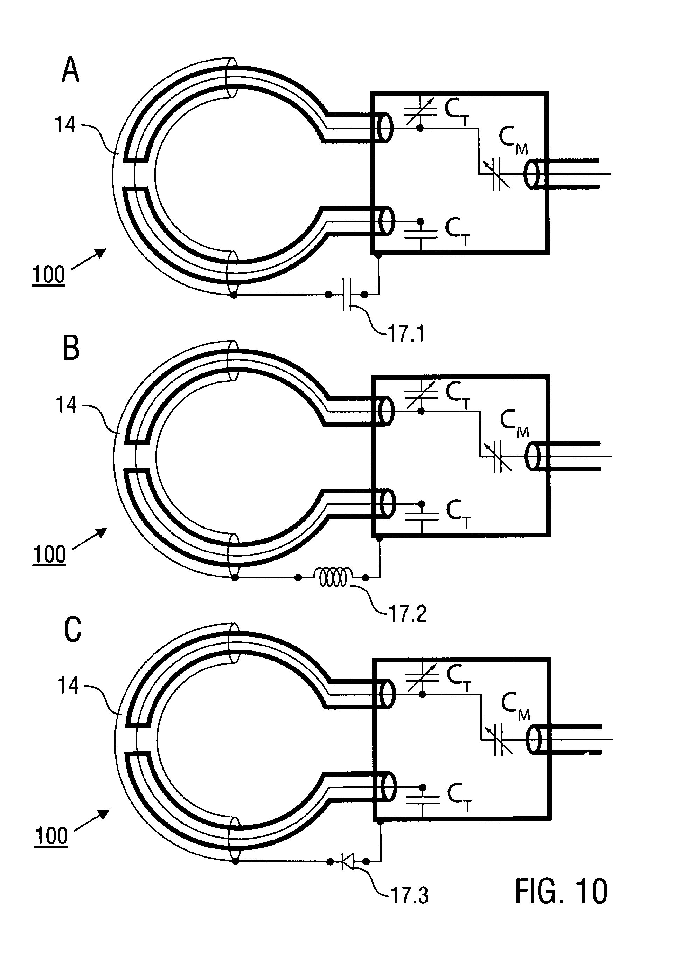

Die Resonanzfrequenz wird entsprechend der Larmor-Frequenz der untersuchten Atomkerne im statischen Magnetfeld des MR-Geräts gewählt. Es sei hier angemerkt, dass die erfindungsgemäße Antenne 100 auf die Larmor-Frequenz für Protonen bei anderen Feldstärken oder auf die Larmor-Frequenz für andere Kerne mit einem von Null verschiedenen Kernspin oder für mehrere Larmor-Frequenzen abgestimmt werden kann. Es soll weiterhin angemerkt werden, dass zur Erfüllung der Resonanzbedingung auch zusätzlich noch entsprechend dimensionierte diskrete Reaktanzen 17.1, 17.2, 17.3 an verschiedenen Stellen der erfindungsgemäßen Antenne 100, z.B. zwischen primären und sekundären Schirm, angebracht werden können (siehe Figur 10).

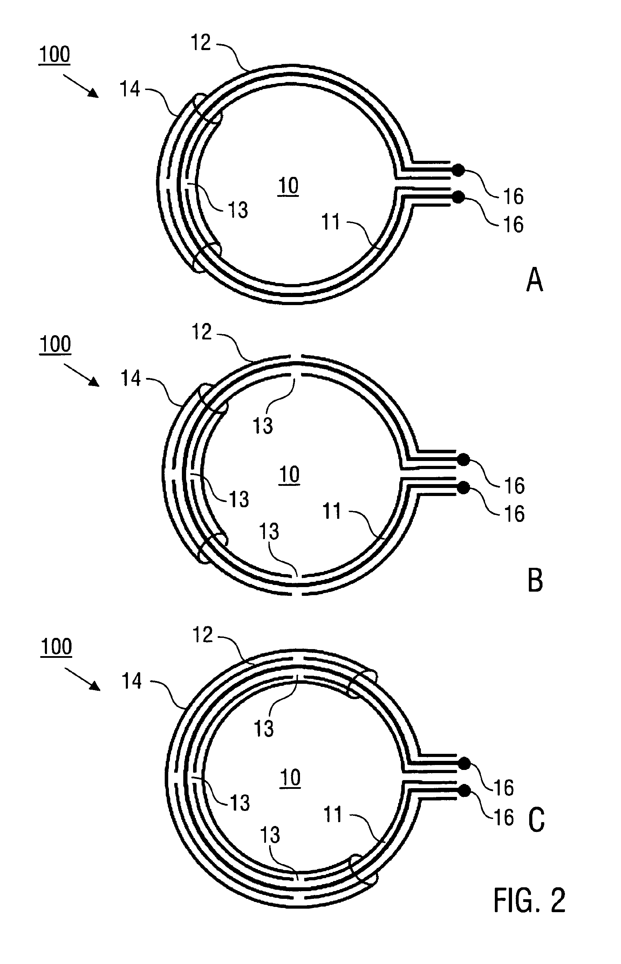

Die Figuren 2A, 2B und 2C illustrieren schematisch weitere Varianten der erfindungsgemäßen Antenne 100 jeweils mit einem kreisförmigen Wellenleiter, der durch den Innenleiter 11 und den primären Schirmleiter 12 gebildet wird. Gemäß Figur 2A ist ein einziger Spalt 13 symmetrisch zu den Speisepunkten 16 vorgesehen, der durch den sekundären Schirmleiter 14 abgedeckt wird. Im Unterschied zu Figur 1A erstreckt sich der sekundäre Schirmleiter 14 nicht über die halbe Leiterschleife, sondern über einen geringeren Winkelbereich. Gemäß Figur 2B weist der primäre Schirmleiter 12 drei Spalte auf, von denen jedoch nur der mittlere Spalt durch den sekundären Schirmleiter 14 bedeckt ist, während zwei weitere Spalte unbedeckt (offen) bleiben. Schließlich illustriert Figur 2C eine Variante mit drei Spalten 13 im primären Schirmleiter 12, die alle durch einen gemeinsamen sekundären Schirmleiter 14 abgedeckt sind.

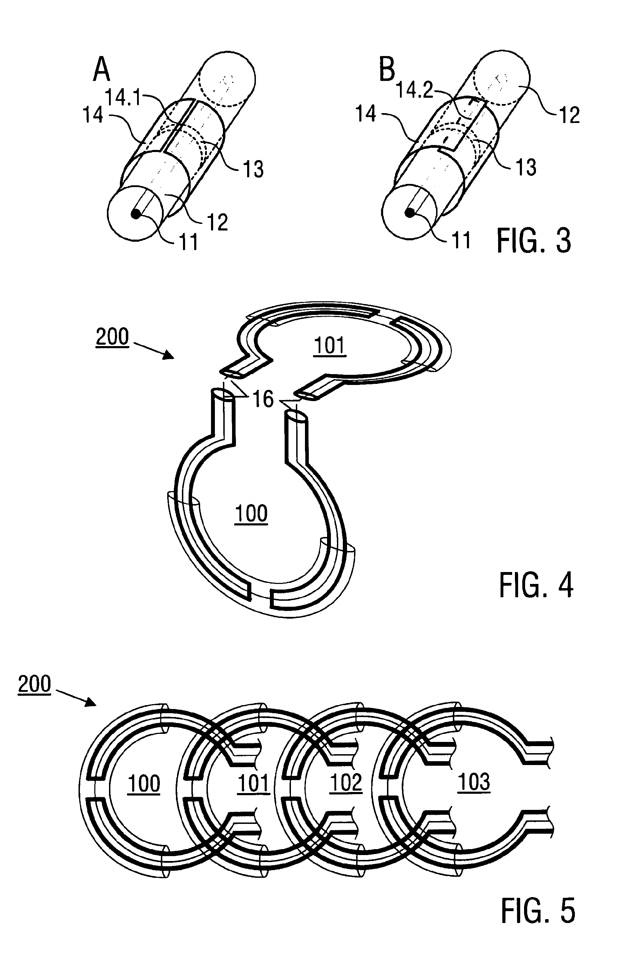

Während bei den Varianten gemäß Figur 2 der sekundäre Schirmleiter 14 eine Rohr- oder Schlauchform hat und den Wellenleiter der Leiterschleife 10 allseitig einschließt, kann gemäß abgewandelten Ausführungsformen der Erfindung der sekundäre Schirmleiter 14 mit einem longitudinalen Schlitz 14.1 (siehe Figur 3A) oder mit einer Überlappung 14.2 (siehe Figur 3B) gebildet sein. Der longitudinale Schlitz 14.1 erstreckt sich in Umfangsrichtung des Wellenleiters, so dass Wirbelströme im sekundären Schirmleiter 14 minimiert werden. Im Fall der Überlappung 14.2 gemäß Figur 3B wird ebenfalls eine Verringerung von Wirbelströmen erreicht, wobei zusätzlich die Abschirmung des Spalts 13 verbessert ist. Die Variante gemäß Figur 3B erlaubt des Weiteren eine spiralförmige Anordnung des sekundären Schirmleiters 14.

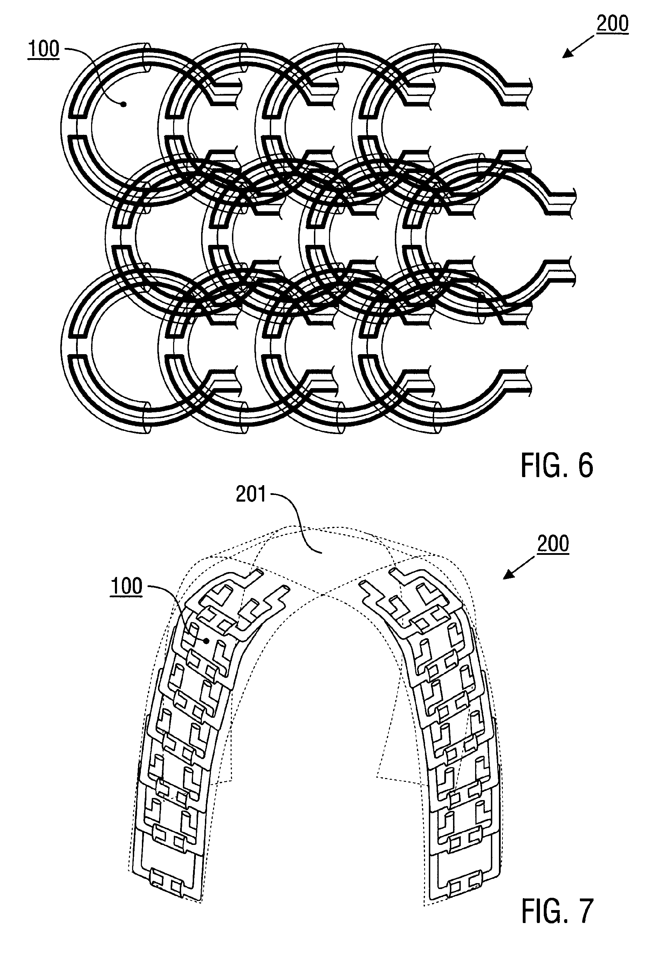

Die Figuren 4 bis 8 illustrieren Ausführungsformen erfindungsgemäßer Antennenanordnungen 200, bei denen mindestens zwei erfindungsgemäße Antennen nebeneinander (siehe Figur 4) oder einander überlappend (siehe Figuren 5 bis 8) entlang einer gekrümmten (siehe Figuren 4, 7 und 8) oder einer ebenen (siehe Figuren 5, 6) Bezugsfläche angeordnet sind. Die Antennenanordnungen 200 sind ohne die Abstimmeinrichtungen der Antennen gezeigt. In der praktischen Umsetzung der Erfindung sind die Abstimmeinrichtungen jeweils unmittelbar angrenzend an die Antennen oder über geschirmte Kabel mit einem Abstand von den Antennen angeordnet.

Bei der in Figur 4 gezeigten Ausführungsform der Antennenanordnung 200 sind zwei Antennen 100, 101 (Durchmesser jeweils z. B. 6 cm) zueinander orthogonal angeordnet. Jede Leiterschleife der Antennen 100, 101 erstreckt sich jeweils in einer Bezugsebene. Beide Bezugsebenen stehen senkrecht aufeinander. Die Antennen 100, 101 sind so angeordnet, dass ihre Speisepunkte 16 zueinander benachbart angeordnet sind, so dass die Verbindung mit einer oder zwei Abstimmeinrichtungen (nicht dargestellt) vereinfacht wird. Die Ausführungsform der Figur 4 wird z.B. bei der MR-Bildgebung zur magnetischen Markierung von arteriellem Blut in der Halsschlagader eines Patienten verwendet (siehe [5]). Es sei angemerkt, dass die beiden erfindungsgemäßen Antennen 100, 101 alternativ in einem anderen geometrischen Winkel als 90° angeordnet werden können, sofern dies vorteilhaft erscheint.

Die beiden erfindungsgemäßen Schleifenantennen können z.B. mit einer Phasendifferenz von 0° (im Sinne einer "Maxwell-Spule") oder von 90° (im Sinne einer "Quadraturspule") oder von 180° (im Sinne einer "Helmholtz-Spule") angesteuert werden, wodurch sich unterschiedliche **B**_{HF}-Felder im Bereich der Halsarterien sowie unterschiedliche **E**_{HF}-Felder im Halsgewebe (und damit unterschiedliche lokale SAR-Werte) erzielen lassen. Bei Bedarf, insbesondere bei hohen Larmor-Frequenzen, bei denen die **B**_{HF}-Ausbreitung im Gewebe bekanntermaßen zunehmend inhomogen wird, kann es auch vorteilhaft sein, durch die Wahl eines von 0°, 90° oder 180° abweichenden Phasenwinkels für die Ansteuerung eine möglichst homogene **B**_{HF}-Verteilung oder eine möglichst große Amplitude des **B**_{HF}-Feldes in einer vorbestimmten Zielregion des Untersuchungsobjekts bei gleichzeitig möglichst geringer SAR einzustellen.

In Figur 5 ist eine weitere Ausführungsform der erfindungsgemäßen Antennenanordnung 200 in Gestalt einer Reihe von Antennen schematisch illustriert. Es wird betont, dass die in Figur 5 gezeigte Ausführungsform lediglich illustrativen Zwecken dient. Die Antennenanordnung 200 kann mindestens zwei oder auch mehr erfindungsgemäße Antennen 100, 101, 102, 103, ... umfassen. Gemäß der gegenwärtig an kommerziell erhältlichen MR-Geräten maximal verfügbaren Anzahl von Empfangskanälen können z.B. bis zu 128 Antennen oder auch mehr Antennen vorgesehen sein. Die erfindungsgemäßen Antennen 100, 101, 102, 103, ... müssen nicht wie dargestellt in einer bestimmten Richtung, z. B. parallel zum statischen Magnetfeld in einem MR-Gerät angeordnet sein. Alternativ können die erfindungsgemäßen Antennen versetzt und/oder mit veränderten Abständen angeordnet sein.

In Figur 6 ist eine zweidimensionale Antennenanordnung 200 schematisch illustriert, die aus erfindungsgemäßen Antennen 100 aufgebaut ist. Die Antennen 100 können gleich oder verschieden aufgebaut sein. So wird ausdrücklich darauf hingewiesen, dass es für bestimmte Untersuchungen günstig sein kann, erfindungsgemäße Antennen aus verschiedenen Ausführungsformen alternierend oder in vorbestimmter Reihenfolge einzusetzen. Erfindungsgemäß können die Antennen auch in Richtung einer Zylinderachse z.B. in Richtung des statischen Magnetfelds **B**₀ des MR-Geräts (z-Richtung) ausgerichtet sein. Es kann aber auch vorteilhaft sein, dass die erfindungsgemäßen Schleifenantennen auf einem Zylindermantel oder anders geformten anatomisch angepassten Formkörper in einem gewissen Winkel zur Richtung des statischen Magnetfelds (z.B. längs einer Helix) angeordnet sind. In diesen Fall erreicht man eine zusätzliche Strukturierung des Sende-/Empfangsprofils in Richtung des statischen Magnetfelds.

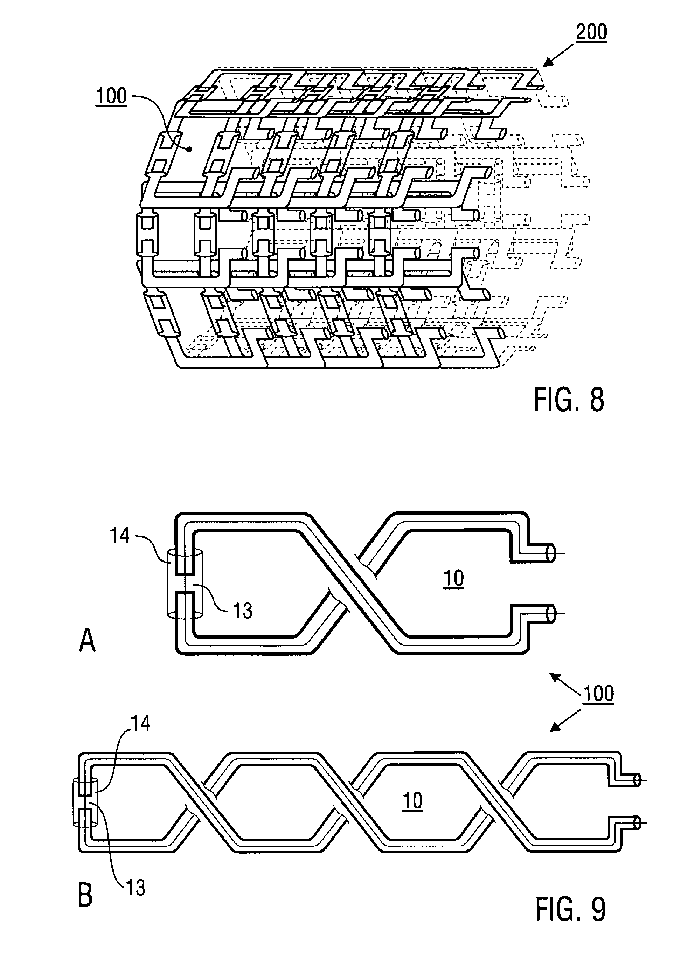

Erfindungsgemäß ist auch die Anordnung einer oder mehrerer Antennen 100 in einer an das untersuchte Objekt angepassten Form möglich, z.B. dom- oder helmähnlich für Untersuchungen des Kopfes (siehe Figur 7) oder auf dem Mantel eines Zylinders (siehe Figur 8) zur Untersuchung der Extremitäten oder als Anordnung in einer oder mehreren ebenen oder gewölbten Flächen für Untersuchungen im Körperstammbereich.

Bei Ausführungsformen gemäß Figur 7 sind mindestens zwei Reihen von aneinandergrenzend, beabstandet oder überlappend angeordneten Antennen 100 vorgesehen, die sich im Betriebszustand der Antennenanordnung 200 auf einer gekrümmten Bezugsfläche erstrecken. Die Bezugsfläche hat eine konkave, einseitig offene Form, so dass ein Raum 2 zur Aufnahme des untersuchten Objekts (nicht dargestellt) geschaffen wird. Die Bezugsfläche hat z.B. die Gestalt einer Halbkugel, eines Halb-Ellipsoiden oder einer Zusammensetzung aus einem Zylinder und einem Ausschnitt einer Kugel oder eines Ellipsoiden. Die mindestens zwei Reihen erfindungsgemäßer Antennen erstrecken sich auf der Bezugsfläche von deren zu der offenen Seite entgegengesetzten Scheitelpunkt 201 in verschiedene Richtungen. Vorzugsweise sind die Reihen der Antennen 100 auf der Bezugsfläche gleichmäßig verteilt und z.B. stern- oder kreuzförmig angeordnet. In der Praxis wird eine Halterung der Antennen 100 durch einen Träger, z.B. aus einem Kunststoffmaterial, gebildet, auf dessen innerer und/oder äußerer Oberfläche die Antennen 100 fixiert sind. Der Träger weist die Gestalt der Bezugsfläche auf, oder er umfasst Streifen zur Halterung der Reihen von Antennen. Des Weiteren kann der Träger die Abstimmeinrichtung(en) der Antennen 100, z.B. am Scheitelpunkt 201 der Bezugsfläche, aufnehmen.

Bei den Ausführungsformen gemäß Figur 8 wird eine Antennenanordnung 200 mit einer Vielzahl von Reihen erfindungsgemäßer Antennen 100 geschaffen, die auf einer Bezugsfläche in Gestalt eines Zylinders in axialer und/oder azimutaler Richtung aneinandergrenzend, beabstandet oder einander überlappend angeordnet sind. Auch in diesem Fall ist ein Träger (nicht dargestellt), z.B. aus einem Kunststoffmaterial, vorgesehen, auf dessen innerer und/oder äußerer Oberfläche die Antennen 100 angeordnet sind und der vorteilhafterweise auch die Abstimmeinrichtung(en) der Antennen 100 aufnehmen kann.

In Figur 9A ist eine weitere Ausführungsform einer erfindungsgemäßen Antenne 100 illustriert, bei der der Wellenleiter der Leiterschleife 10 so angeordnet ist, dass zwei gegeneinander um 180° verdrehte rechteckige Leiterabschnitte resultieren und die gesamte Anordnung eine geometrische Form gemäß der Ziffer "8" bildet. Der Spalt 13 und der sekundäre Schirmleiter 14 sind in einem der Leiterabschnitte vorgesehen. Neben dieser aus zwei kreisförmigen Leiterabschnitten gebildeten Anordnung kann es für bestimme Anwendungen auch günstig sein, eine ansonsten analoge Antenne in Form der Ziffer "8" aus zwei Kreisen, zwei Ellipsen oder zwei anders geformten Polygonzüge aufzubauen.

In analoger Weise können auch drei oder mehr kreisförmige, elliptische, rechteckige oder durch andere Polygonzüge gebildete Schleifen so kombiniert werden, dass eine Kette aus jeweils um 180° gegeneinander verdrehten Abschnitten gebildet wird und die gesamte Anordnung in Längsrichtung eine geometrische Form gemäß einer n-fachen Ziffer "8" bildet (n = 1, 3/2, 2, ...). Als Beispiel zeigt Figur 9B eine Anordnung entsprechend einer "Doppelacht".

Es sei angemerkt, dass einzelne erfindungsgemäße Antennen 100 oder Gruppen erfindungsgemäßer Antennen mittels an sich bekannter Techniken auf unterschiedliche Larmor-Frequenzen abgestimmt werden können. Der Abstimmzustand kann ggf. mittels schneller Schaltdioden auch schaltbar gestaltet werden. Es ist aber auch denkbar, für die Abstimmung der Schleifenantennen Netzwerke einzusetzen, die beispielsweise aus einem Parallelschwingkreis (Tank) und einem in Reihe geschalteten Kondensator bestehen, und die eine gleichzeitige Abstimmung auf mehrere Larmor-Frequenzen ermöglichen.

Die Figuren 10A und 10B zeigen exemplarisch wie in Figur 1 Ausführungsformen erfindungsgemäßer Antennen 100, bei denen ein Kondensator 17.1 (Figur 10A) bzw. eine Induktivität 17.2 (Figur 10B) den sekundären Schirmleiter 14 gegen Massepotential schaltet. In Figur 10C ist exemplarisch eine Ausführungsform gezeigt, bei der der sekundäre Schirmleiter 14 einer erfindungsgemäßen Antenne 100 über eine Diode 17.3 gegen Massepotential geschaltet wird.

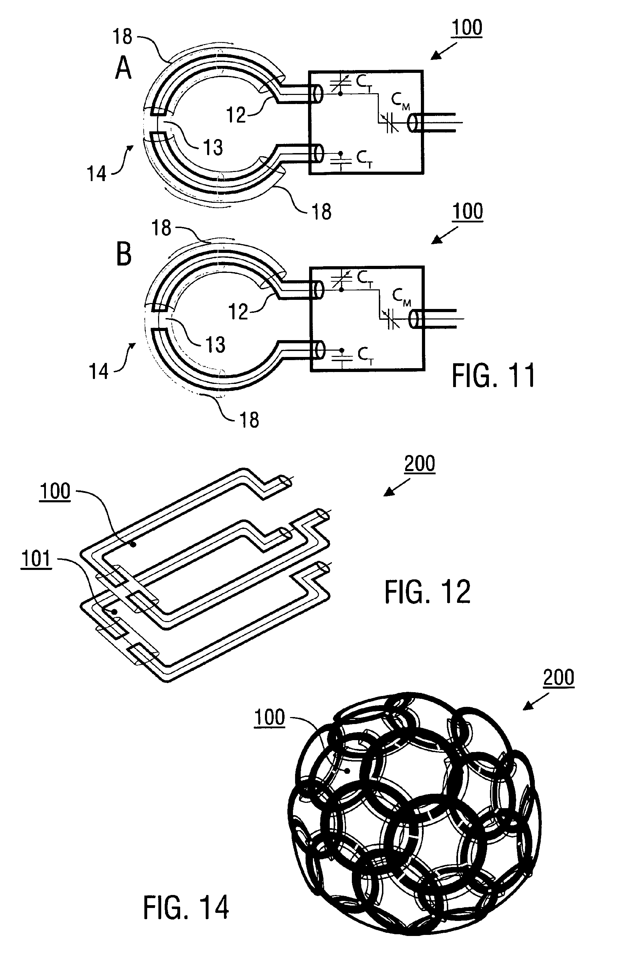

Erfindungsgemäß ist der sekundäre Schirmleiter 14 so gestaltet, dass durch eine Veränderung seiner Ausdehnung die Abstimmung der Antenne 100 auf eine Larmor-Frequenz eingestellt werden kann. So sind bei den Ausführungsformen der Figur 11 sind zwei oder mehr röhrenförmige Schirmabschnitte 18 des sekundären Schirmleiters 14 überlappend angeordnet und dabei leitend, z.B. durch einen Schleifkontakt, miteinander verbunden. Durch mechanische Variation der relativen Position der Schirmabschnitte 18 wird der resultierende Schirmleiter 14 entweder in einer Richtung (Figur 11B) oder in zwei Richtungen (Figur 11A) einseitig oder an zwei Seiten verlängert oder verkürzt. Die Verlängerung oder Verkürzung kann je nach Art des MR-Experiments symmetrisch oder nicht symmetrisch mit Bezug auf den Spalt 13 im primären Schirmleiter des Wellenleiters erfolgen. Neben der Einstellung eines gewünschten Abstimmungsverhaltens lässt sich dadurch auch die räumliche Verteilung der **B**_{HF}- und **E**_{HF}-Felder im Untersuchungsobjekt beeinflussen.

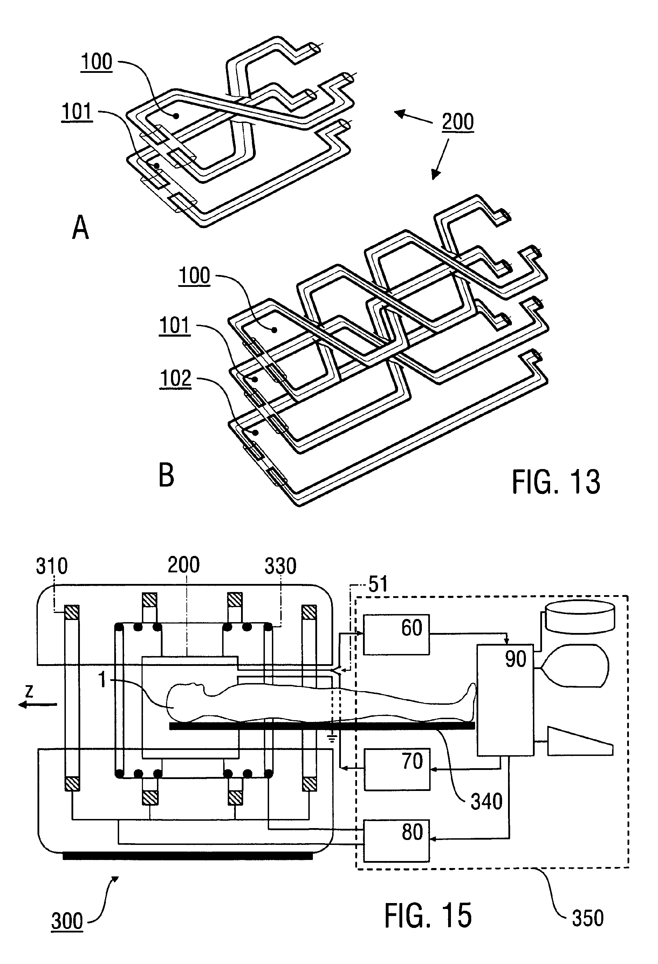

Die Figuren 12 und 13 illustrieren schematisch Ausführungsformen erfindungsgemäßer Antennenanordnungen 200, bei denen erfindungsgemäße Antennen 100, 101, 102 stapelförmig übereinander angeordnet sind. In Abhängigkeit von der konkreten Anwendung können wie dargestellt zwei Antennen 100, 101 oder alternativ eine größere Anzahl von Antennen kombiniert werden. Des Weiteren können in Abhängigkeit von der gewünschten Antennencharakteristik (Antennenempfindlichkeit) zwei oder mehr gleichartige (Figur 12) oder zwei oder mehr verschiedene (Figuren 13A und 13B) Antennen 100, 101, 102 kombiniert werden.

Figur 14 illustriert beispielhaft die Kombination einer Vielzahl erfindungsgemäßer Antennen 100, die einander überlappend auf einer sphärischen Bezugsfläche angeordnet sind, in schematischer Draufsicht. Die Antennen 100 können jeweils einzeln oder gruppenweise mit separaten Abstimmeinrichtungen verbunden sein, um in Abhängigkeit von dem untersuchten Objekt gezielt die Antennencharakteristik der Antennenanordnung 200 und/oder die Resonanzfrequenzen einzustellen.

In Figur 15 ist eine bevorzugte Ausführungsform eines erfindungsgemäßen MR-Geräts 300, das mindestens eine erfindungsgemäße Antenne oder Antennenanordnung 200 umfasst, in schematischer Schnittansicht illustriert. Das MR-Gerät 300 ist, abgesehen von der Antenne oder Antennenanordnung 200, im Wesentlichen wie ein herkömmliches MR-Gerät aufgebaut. Es umfasst eine Hauptspule 310, die zur Erzeugung des statischen Magnetfeldes B₀ in z-Richtung eingerichtet ist, die Sende-/Empfangsspule 200, die durch mindestens eine erfindungsgemäße Antenne oder Antennenanordnung gebildet wird, mindestens eine Gradientenspule 330, die zur Ortskodierung der Signale vorgesehen ist, einen Probenträger 340, der zur Aufnahme des zu untersuchenden Objekts 1 (z. B. ein menschlicher Körper oder Teile von diesem) eingerichtet ist, und eine Steuereinheit 350, deren Komponenten insbesondere zur Steuerung, Energieversorgung, Datenaufnahme und Bedienung des MR-Geräts 300 vorgesehen sind. Die Steuereinheit 350 umfasst insbesondere einen Hochfrequenz-Empfänger 60 und einen Hochfrequenz-Sender 70, eine Stromversorgung 80 und einen Steuerrechner 90, der mit weiteren Peripheriegeräten, z. B. einem Datenspeicher, einem Sichtgerät und einer Bedienungseinheit verbunden ist. Ein Umschalter 51 ist zum Umschalten der Sende-/Empfangsspule 320 (Antenne 100) zwischen dem Sende- und Empfangsbetrieb vorgesehen. Der Umschalter 51 kann auch mehrfach, z.B. für Antennengruppen der Antennenanordnung 200 oder mehrere Antennenanordnungen 200 vorgesehen sein.

Die in der vorstehenden Beschreibung, den Zeichnungen und den Ansprüchen offenbarten Merkmale der Erfindung können einzeln oder auch in Kombination für die Verwirklichung der Erfindung in ihren verschiedenen Ausgestaltungen von Bedeutung sein.

## Patentansprüche

1. Antenne (100), die für eine Anregung und/oder Erfassung einer Magnetresonanz in einem zu untersuchenden Objekt (1) eingerichtet ist, umfassend:
- eine Leiterschleife (10) mit einem Innenleiter (11) und einem primären Schirmleiter (12), die mindestens einen Wellenleiter bilden, wobei
- der primäre Schirmleiter (12) durch mindestens einen Spalt (13) unterbrochen ist,
**gekennzeichnet durch**
- einen sekundären Schirmleiter (14), der den primären Schirmleiter (12) umgibt, wobei ein Dielektrikum (15) zwischen dem primären Schirmleiter (12) und dem sekundären Schirmleiter (14) angeordnet und mindestens der mindestens eine Spalt **durch** den sekundären Schirmleiter (14) abgedeckt ist, wobei
- der sekundären Schirmleiter (14) mindestens zwei Schirmleiterabschnitte (18) umfasst, die miteinander elektrisch leitend verbunden und relativ zueinander verschiebbar sind, so dass die Länge des sekundären Schirmleiters (14) veränderlich ist.

2. Antenne gemäß Anspruch 1, bei der
- der sekundäre Schirmleiter (14) entlang der Umfangsrichtung der Leiterschleife (10) in Bezug auf den mindestens einen Spalt (13) symmetrisch angeordnet ist,
- der sekundäre Schirmleiter (14) den Wellenleiter vollständig umgibt oder entlang der Umfangsrichtung der Leiterschleife (10) einen Schlitz aufweist, oder
- der sekundäre Schirmleiter (14) eine Hülsen-, Netz- oder Spiralform aufweist.

3. Antenne gemäß einem der vorhergehenden Ansprüche, bei der
- der sekundäre Schirmleiter (14) über mindestens eines von mindestens einer Kapazität (17.1), mindestens einer Induktivität (17.2) und mindestens einer Diode (17.3) mit dem primären Schirmleiter verbunden ist.

4. Antenne gemäß einem der vorhergehenden Ansprüche, bei der
- die Leiterschleife (10) eine Kreis-, Ellipsen- oder Vieleckform, insbesondere Rechteckform, aufweist, und
- die Leiterschleife (10) eine Form gemäß der Ziffer Acht oder halbzahliger Vielfacher der Form gemäß der Ziffer Acht aufweist.

5. Antenne gemäß einem der vorhergehenden Ansprüche, bei der
- die Leiterschleife (10) ein Koaxialkabel umfasst, dessen Enden die Speisepunkte (16) der Antenne (100) bilden, wobei
- der primäre Schirmleiter (12) eine Isolatorschicht trägt, die das Dielektrikum (15) bildet, und
- der sekundäre Schirmleiter (14) eine elektrisch leitende Schicht auf der Isolatorschicht umfasst.

6. Antenne gemäß einem der vorhergehenden Ansprüche, bei der
- der sekundäre Schirmleiter (14) entlang der Umfangsrichtung der Leiterschleife (10) eine Länge hat, die mindestens die dreifache Breite des Spaltes (13) beträgt,
- das Dielektrikum (15) eine Dicke von mindestens 10 µm, insbesondere mindestens 50 µm aufweist, und
- das Dielektrikum (15) durch mindestens einen von den aus der Elektrotechnik bekannten Isolatoren, insbesondere von hydrophoben Kunststoffen wie Polyolefinen, Polytetrafluorethylen oder Phenolharzen, einem Metalloxid, einem Gas, einer Keramik, einem Glas, einem Mineral oder Vakuum gebildet wird.

7. Antenne gemäß einem der vorhergehenden Ansprüche, die umfasst:
- eine Abstimmeinrichtung (20), die zur Abstimmung der Antenne auf mindestens eine Larmor-Frequenz eingerichtet ist,
- eine Schalteinrichtung, mit der die Empfindlichkeit der Antenne bzw. der Antennenanordnung veränderlich ist, und/oder
- einen Umschalter, der zur Verbindung der Antenne jeweils mit einem Empfänger oder einem Sender eines Magnetresonanzgeräts eingerichtet ist.

8. Antennenanordnung (200), die mehrere Antennen (100, 101, 102) gemäß einem der vorhergehenden Ansprüche umfasst.

9. Antennenanordnung gemäß Anspruch 8, bei der
- die Antennen (100, 101, 102) so angeordnet sind, dass mindestens zwei Leiterschleifen (10) sich überlappen, aneinander grenzen oder einen gegenseitigen Abstand aufweisen oder die Antennen (100, 101, 102) einen Antennenstapel bilden.

10. Antennenanordnung gemäß einem der Ansprüche 8 bis 9, bei der
- die Leiterschleifen (10) verschiedene Formen oder Größen aufweisen.

11. Antennenanordnung gemäß einem der Ansprüche 8 bis 10, bei der
- die Antennen so angeordnet sind, dass sich die Leiterschleifen (10) auf einer gekrümmten Bezugsfläche erstrecken.

12. Magnetresonanzgerät (300), das
- zur Erzeugung eines statischen Magnetfeldes mit einer vorbestimmten Magnetfeldrichtung (z) eingerichtet ist, und
- mindestens eine Antenne (100) oder eine Antennenanordnung (200) gemäß einem der Ansprüche 1 bis 11 umfasst.

13. Verfahren zur Magnetresonanz-Bildgebung oder Magnetresonanz-Spektroskopie, mit den Schritten:
- Anregung und/oder Erfassung einer Magnetresonanz in einem zu untersuchenden Objekt (1) mit einer Antenne (100) oder einer Antennenanordnung (200) gemäß einem der Ansprüche 1 bis 11.

14. Verfahren gemäß Anspruch 13, bei dem
- die Antenne (100) als Sende-Antenne, Empfangs-Antenne oder als Sende-Empfangs-Antenne oder im alternierenden Betrieb oder für eine sendeseitige oder empfangsseitige Parallelbildgebungs-Technik oder eine Kombination aus beiden Verfahren verwendet wird.

15. Verfahren gemäß Anspruch 13 oder 14, bei dem
- die Antenne (100) durch eine Einstellung einer Länge des sekundären Schirmleiters (14) entlang der Umfangsrichtung der Leiterschleife (10) und/oder eine Einstellung einer kapazitiven oder induktiven Kopplung des sekundären Schirmleiters (14) mit dem primären Schirmleiter (12) auf eine vorbestimmte Larmorfrequenz abgestimmt wird.

## Claims

1. An antenna (100), which is adapted for exciting and/or detecting a magnetic resonance in an object (1) to be examined, comprising:
- a conductor loop (10) with an inner conductor (11) and a primary shielding conductor (12) that form at least one waveguide, wherein
- the primary shielding conductor (12) is interrupted by at least one gap (13),
**characterized by**
- a secondary shielding conductor (14), which surrounds the primary shielding conductor (12), wherein a dielectric (15) is arranged between the primary shielding conductor (12) and the secondary shielding conductor (14) and at least the at least one gap is covered by the secondary shielding conductor (14), wherein
- the secondary shielding conductor (14) comprises at least two shielding conductor sections (18), that are connected in an electrially conductive manner and are shiftable relative to one another, so that the length of the secondary shielding conductor (14) is variable.

2. The antenna according to claim 1, in which
- the secondary shielding conductor (14) is arranged symmetrically along the circumferential direction of the conductor loop (10) with respect to the at least one gap (13),
- the secondary shielding conductor (14) surrounds the waveguide fully or has a slit along the circumferential direction of the conductor loop (10), or
- the secondary shielding conductor (14) has a sleeve-, network- or spiral shape.

3. The antenna according to one of the preceding claims, in which
- the secondary shielding conductor (14) is connected via at least one of at least one capacitance (17.1), at least one inductance (17.2) and at least one diode (17.3) with the primary shielding conductor.

4. The antenna according to one of the preceding claims, in which
- the conductor loop (10) has a circular, elliptic or polygon shape, in particular a rectangular shape, and
- the conductor loop (10) has a shape according to the numeral eight or half-digit multiplier of the shape according to the numeral eight.

5. The antenna according to one of the preceding claims, in which
- the conductor loop (10) comprises a coaxial cable, the ends of which form the feed points (16) of the antenna (100), wherein
- the primary shielding conductor (12) carries an insulator layer, which forms the dielectric (15), and
- the secondary shielding conductor (14) comprises an electrically conductive coating on the insulator layer.

6. The antenna according to one of the preceding claims, in which
- the secondary shielding conductor (14) has along the circumferential direction of the conductor loop (10) a length, which is at least the triple width of the gap (13),
- the dielectric (15) has a thickness of at least 10 µm, in particular at least 50 µm, and
- the dielectric (15) is formed by at least one of the insulators known in the field of electrical engineering, in particular by hydrophobic plastics like polyolefines, polytetrafluoroethylene or phenolic resins, a metal oxide, a gas, a ceramic, a glass, a mineral or vacuum.

7. The antenna according to one of the preceding claims, which comprises:
- a tuning device (20) which is arranged for tuning the antenna to at least one Larmor frequency,
- a switching device by means of which the sensitivity of the antenna or the antenna arrangement can be varied, and/or
- a change-over switch, which is adapted for connecting the antenna with a receiver or a transmitter of a magnetic resonance device.

8. An antenna arrangement (200), which comprises a plurality of antennas (100, 101, 102) according to one of the preceding claims.

9. The antenna arrangement according to claim 8, in which
- the antennas (100, 101, 102) are arranged such that at least two conductor loops (10) are overlapping, adjacent to each other, or are at a distance from each other.

10. The antenna arrangement according to one of the claims 8 to 9, in which
- the conductor loops (10) have different shapes or sizes.

11. The antenna arrangement according to one of the claims 8 to 10, in which
- the antennas are arranged in such a way that the conductor loops (10) extend along a curved reference surface.

12. A magnetic resonance device (300), which
- is adapted to generate a static magnetic field with a predetermined magnetic field direction (z), and
- at least one antenna (100) or an antenna arrangement according to one of the claims 1 to 11.

13. A method for magnetic resonance imaging or magnetic resonance spectroscopy, including the steps of:
- exciting and/or detecting a magnetic resonance in an object (1), which is to be examined, with an antenna (100) or an antenna arrangement (200) according to one of the claims 1 to 11.

14. The method according to claim 13, in which
- the antenna (100) is used as a transmitting antenna, a receiving antenna or a transmitting-receiving antenna or in alternating operation, or for a transmission-side or reception side parallel imaging technique or a combination of both methods.

15. The method according to claim 13 or 14, in which
- the antenna (100) is tuned by setting a length of the secondary shielding conductor (14) along the circumferential direction of the conductor loop (10) and/or an adjustment of a capacitive or inductive coupling of the secondary shielding conductor (14) with the primary shielding conductor (12) to a predefined Larmor frequency.

## Revendications

1. Antenne (100), qui est mise au point pour exciter et/ou détecter une résonance magnétique dans un objet (1) à examiner, comprenant :
- une boucle conductrice (10) pourvue d'un conducteur intérieur (11) et d'un conducteur blindé primaire (12), qui forment au moins un guide d'ondes, sachant que
- le conducteur blindé primaire (12) est interrompu par au moins une fente (13),
**caractérisée par**
- un conducteur blindé secondaire (14), qui entoure le conducteur blindé primaire (12), sachant qu'un diélectrique (15) est disposé entre le conducteur blindé primaire (12) et le conducteur blindé secondaire (14) et la fente au moins au nombre de une est dissimulée par le conducteur blindé secondaire (14), sachant que
- le conducteur blindé secondaire (14) comprend au moins deux segments de conducteur blindé (18), qui sont reliés l'un à l'autre de manière électroconductrice et peuvent être déplacés par coulissement les uns par rapport aux autres de sorte que la longueur du conducteur blindé secondaire (14) peut varier.

2. Antenne selon la revendication 1, dans le cadre de laquelle
- le conducteur blindé secondaire (14) est disposé de manière symétrique par rapport à la fente (13) au moins au nombre de une le long du sens périphérique de la boucle conductrice (10),
- le conducteur blindé secondaire (14) entoure intégralement le guide d'ondes ou présente, le long du sens périphérique de la boucle conductrice (10), une entaille, ou
- le conducteur blindé secondaire (14) présente une forme de douille, de grille ou de spirale.

3. Antenne selon l'une quelconque des revendications précédentes, dans le cadre de laquelle
- le conducteur blindé secondaire (14) est relié, par l'intermédiaire d'au moins un parmi au moins une capacité (17.1), au moins une inductance (17.2) et au moins une diode (17.3), au conducteur blindé primaire.

4. Antenne selon l'une quelconque des revendications précédentes, dans le cadre de laquelle
- la boucle conductrice (10) présente une forme circulaire, une forme elliptique ou une forme polygonale, en particulier une forme rectangulaire, et
- la boucle conductrice (10) présente une forme selon le chiffre huit ou un multiple demi-entier de la forme selon le chiffre huit.

5. Antenne selon l'une quelconque des revendications précédentes, dans le cadre de laquelle
- la boucle conductrice (10) comprend un câble coaxial, dont les extrémités forment les points d'alimentation (16) de l'antenne (100), sachant que
- le conducteur blindé primaire (12) supporte une couche à isolateur, qui forme le diélectrique (15), et
- le conducteur blindé secondaire (14) comprend une couche électroconductrice sur la couche à isolateur.

6. Antenne selon l'une quelconque des revendications précédentes, dans le cadre de laquelle
- le conducteur blindé secondaire (14) a, le long du sens périphérique de la boucle conductrice (10), une longueur, qui présente une valeur au moins égale à trois fois la largeur de la fente (13),
- le diélectrique (15) présente une épaisseur d'au moins 10 µm, en particulier d'au moins 50 µm, et
- le diélectrique (15) est formé par au moins l'un des isolateurs connus du domaine de l'électrotechnique, en particulier des matières plastiques hydrophobes telles que les polyoléfines, les polytétrafluoroéthylènes ou les résines phénoliques, un oxyde métallique, un gaz, une céramique, un verre, un minéral ou le vide.

7. Antenne selon l'une quelconque des revendications précédentes, laquelle comprend :
- un système de syntonisation (20) qui est mis au point pour syntoniser l'antenne sur au moins une fréquence de Larmor,
- un système de commutation, lequel permet de faire varier la sensibilité de l'antenne ou de l'ensemble d'antennes, et/ou
- un commutateur, qui est mis au point pour relier l'antenne respectivement à un récepteur ou à un émetteur d'un appareil à résonance magnétique.

8. Ensemble d'antennes (200), qui comprend plusieurs antennes (100, 101, 102) selon l'une quelconque des revendications précédentes.

9. Ensemble d'antennes selon la revendication 8, dans le cadre duquel
- les antennes (100, 101, 102) sont disposées de telle manière qu'au moins deux boucles conductrices (10) se chevauchent, sont adjacentes les unes aux autres ou présentent un espacement réciproque ou les antennes (100, 101, 102) forment une pile d'antennes.

10. Ensemble d'antennes selon l'une quelconque des revendications 8 à 9, dans le cadre duquel
- les boucles conductrices (10) présentent différentes formes ou tailles.

11. Ensemble d'antennes selon l'une quelconque des revendications 8 à 10, dans le cadre duquel
- les antennes sont disposées de telle manière que les boucles conductrices (10) s'étendent sur une face de référence incurvée.

12. Appareil à résonance magnétique (300), qui
- est mis au point pour générer un champ magnétique statique pourvu d'un sens de champ magnétique (z) défini, et
- comprend au moins une antenne (100) ou un ensemble d'antennes (200) selon l'une quelconque des revendications 1 à 11.

13. Procédé d'imagerie par résonance magnétique ou de spectroscopie par résonance magnétique, comprenant les étapes qui suivent consistant à :
- exciter et/ou détecter une résonance magnétique dans un objet (1) à examiner à l'aide d'une antenne (100) ou d'un ensemble d'antennes (200) selon l'une quelconque des revendications 1 à 11.

14. Procédé selon la revendication 13, dans le cadre duquel
- l'antenne (100) est utilisée en tant qu'antenne émettrice, antenne réceptrice ou antenne émettrice-réceptrice ou selon un fonctionnement en alternance ou pour une technique d'imagerie parallèle côté émission ou côté réception ou pour une combinaison des deux procédés.

15. Procédé selon la revendication 13 ou 14, dans le cadre duquel
- l'antenne (100) est syntonisée sur une fréquence de Larmor prédéfinie par un réglage d'une longueur du conducteur blindé secondaire (14) le long du sens périphérique de la boucle conductrice (10) et/ou par un réglage d'un couplage capacitif ou inductif du conducteur blindé secondaire (14) au conducteur blindé primaire (12).
